# EUROPÄISCHE PATENTSCHRIFT

(11) **EP 3 993 025 B1**
(45) Veröffentlichungstag und Bekanntmachung des Hinweises auf die Patenterteilung: **03.12.2025**
(21) Anmeldenummer: 21203558.8
(22) Anmeldetag: 19.10.2021
(51) Int. Cl.: H01L 23/367, H01L 23/373, H01L 23/42

(54) **KOMPENSATIONSBAUTEIL**
COMPENSATION COMPONENT
COMPOSANT DE COMPENSATION

(30) Priorität: 29.10.2020 DE 102020128453
(43) Veröffentlichungstag der Anmeldung: 04.05.2022
(73) Patentinhaber: Erwin Quarder Systemtechnik GmbH, 32339 Espelkamp (DE)
(72) Erfinder: Siewert, Georg, 32351 Stemwede (DE)
(74) Vertreter: Geskes, Christoph

(56) Entgegenhaltungen:
- EP-A1- 1 901 350
- US-A1- 2008 292 840
- US-A1- 2016 035 646

## Beschreibung

Die vorliegende Erfindung betrifft ein Kompensationsbauteil mit einer ersten, vorzugsweise quaderförmigen Materiallage aus wärmeleitendem Materialart, insbesondere Metall, vorzugsweise Kupfer, mit einer mit Abstand zu der ersten Materiallage, insbesondere in einer parallelen Ebene zu dieser verlaufenden, vorzugsweise quaderförmigen zweiten wärmeleitenden Materiallage, insbesondere einer anderen zweiten, bevorzugt elektrisch nicht leitenden Materialart, wie etwa Keramik.

Bekanntermaßen ist eine Kühlung von elektronischen Chips oder anderen elektronischen (Hochleistungs-)Bauteilen einer elektronischen Vorrichtung wichtig, um eine ausreichende Lebensdauer des elektronischen Bauteils zu ermöglichen. Hierbei sind diverse Randbedingungen zu beachten. Insofern die zu kühlenden elektronischen Bauteile beispielsweise bei Elektro-Fahrzeugen eingesetzt werden sollen, wie etwa in einem Inverter eines Elektro-Fahrzeugs, der die Gleichspannung der Akkus des Fahrzeugs in Wechselspannung wandelt, steht in der Regel für die Kühlung nur ein begrenzter Bauraum zur Verfügung. Dabei muss die Wärmeabführung von dem elektronischen Chip auch bei hohen Umgebungstemperaturen gewährleistet werden. Weiter müssen sämtliche an der Kühlung beteiligten Bauteile über einen großen Temperaturbereich (Winter/Sommer) einsetzbar sein, ohne dabei Schaden zu nehmen.

Zur Kühlung von elektronischen Chips können beispielsweise blockartige Kühlkörper aus Metall, wie etwa Kupfer, eingesetzt werden, auf denen die Chips befestigt werden und die deren im Betrieb entstehende Wärme weiterleiten bzw. von den Chips ableiten. In der Regel sitzen die Chips dabei auf einer geeigneten Leiterplatte.

Bei besonders hohen Anforderungen bzw. besonders großer Betriebswärme des jeweiligen elektronischen Bauteils muss die Wärme von den Kühlkörpern ebenfalls explizit abgeleitet werden. Hierzu ist es denkbar, von einem Kühlmedium durchflossene Kühlbauteile mit metallischer Kühlplatte oder dergleichen einzusetzen und den Kühlkörper beispielsweise auf die Kühlplatte unmittelbar aufzusetzen und mit der Kühlplatte direkt zu verbinden, etwa stoffschlüssig. Dies ist allerdings problematisch. Denn insofern unterschiedliche Materialarten für den Kühlkörper einerseits und die Kühlplatte andererseits eingesetzt werden und/oder unterschiedliche Dicken dieser Bauteile verwendet werden, besteht aufgrund der unterschiedlichen Wärmeausdehnungskoeffizienten der beteiligten Materialien bzw. Bauteile und der damit einhergehenden unterschiedlichen Längenänderungen bei sich insbesondere ändernden (Umgebungs-)Temperaturen das Risiko, bei einer solchen unmittelbaren Verbindung des Kühlkörpers mit der Kühlplatte entsprechende temperaturabhängige Kräfte auszulösen, die diese Verbindung der beiden Bauteile zerstören können. Eine besondere Herausforderung besteht zudem darin, dass Kühlplatten von mit einem Kühlmedium durchflossenden Kühlbauteilen in der Regel aus metallischem und somit elektrisch leitenden Material bestehen, häufig aber eine elektrische Isolation des (metallischen) Kühlkörpers von der (metallischen) Kühlplatte erforderlich ist.

Aus der EP 1 901 350 A1 geht eine Wärmeableitungsvorrichtung hervor, die ein isolierendes Substrat umfasst, an dessen erster Seite ein wärmeerzeugendes Element befestigt werden kann und an dessen zweiter Seite ein Kühlkörper befestigt ist. An der zweiten Seite des isolierenden Substrats ist außerdem eine Metallschicht angeordnet und zwischen der Metallschicht und dem Kühlkörper ist ein Spannungsrelaxationselement ausgebildet, das aus einem hochwärmeleitenden Material besteht und einen plattenförmigen Körper mit einer Vielzahl von darauf in Abständen voneinander ausgebildeten Erhebungen aufweist. Die Endflächen der Erhebungen sind mit der Metallschicht verlötet und die Seite des plattenförmigen Körpers ist mit dem Kühlkörper verbunden.

Die US 2016/035646 A1 beschreibt eine Halbleitervorrichtung, bei der ein Halbleiterelement auf einem isolierenden Substrat angebracht und mit einem Strahlungsblock verbunden ist. Der Strahlungsblock ist aus einem hoch(wärme)leitenden Material und umfasst einen dreidimensionalen Strahlungsabschnitt und einen Basisabschnitt, wobei der Strahlungsabschnitt pinartige Elemente umfasst, die eine vergrößerte Oberfläche zur besseren Wärmeableitung bilden.

In der US 2008/292840 A1 wird eine thermisch und elektrisch leitfähige Struktur beschrieben, die eine flexible Polymermatrix umfasst, an der vertikal ausgerichtete Kohlenstoff-Nanostrukturen angeordnet sind, beispielsweise an gegenüberliegenden Seiten der flexiblen Polymermatrix.

Ausgehend hiervon ist es Aufgabe der vorliegenden Erfindung, in einer Konstellation, in der allgemein gesprochen zwei thermisch leitende Materiallagen unterschiedlicher Materialart und/oder Materialdicke wärmeleitend miteinander verbunden werden sollen, einerseits für eine gute Wärmeleitung zwischen diesen Materiallagen zu sorgen und andererseits dabei aber Kräfte zu kompensieren, die bei sich ändernden Temperaturen aufgrund der unterschiedlichen Materialarten und/oder Materialdicken entstehen können.

Diese Aufgabe wird gelöst durch ein Kompensationsbauteil mit einer ersten, vorzugsweise quaderförmigen Materiallage, insbesondere einer ersten wärmeleitenden Materialart, insbesondere Metall, vorzugsweise Kupfer, mit einer mit Abstand zu der ersten Materiallage insbesondere in einer parallelen Ebene zu dieser verlaufenden, vorzugsweise quaderförmigen zweiten Materiallage aus wärmeleitendem Material, vorzugsweise einer zweiten, anderen, insbesondere elektrisch nicht leitenden Materialart, bevorzugt Keramik, wobei zwischen den beiden Materiallagen zur Übertragung von Wärme von der einen zur anderen Materiallage und zur Kompensation von unterschiedlichen, winklig, vorzugsweise senkrecht zu ihrer jeweiligen Längserstreckung auftretenden mechanischen Kräften mehrere parallel mit Abstand zueinander angeordnete, längliche, insbesondere zylindrische, bevorzugt elastisch verformbare Wärmeübertragungselemente verlaufen, vorzugsweise aus der ersten Materialart.

Mit einem solchen Kompensationsbauteil ist es möglich, zwei Materiallagen unterschiedlicher Materialart und/oder Materialdicke mit bei sich ändernden Temperaturen insofern unterschiedlichem Dehnungsverhalten derart wärmeleitend miteinander zu verbinden, dass die bereits erwähnten, ggf. auftretenden Kräfte bzw. Spannungen vermieden oder reduziert werden können.

Dabei sind die einzelnen länglichen Wärmeübertragungselemente entsprechend derart ausgebildet, insbesondere durch geeignete Materialwahl und/oder Dimensionierung, dass sie zum einen für die eigentliche Wärmeübertragung zwischen der ersten Materiallage und der zweiten Materialart sorgen können und zum anderen die genannten Kräfte kompensieren können.

Die Wärmeübertragungselemente sind zwischen einer ersten (insbesondere großflächigen) Seite der zweiten Materiallage und der ersten Materiallage angeordnet.

Erfindungsgemäß weist die zweite Materiallage eine ihrer ersten Seite gegenüberliegende (insbesondere großflächige) zweite Seite auf und das Kompensationsbauteil eine dritte, vorzugsweise quaderförmige Materiallage, insbesondere ebenfalls der ersten Materialart, die mit Abstand, insbesondere in einer parallelen Ebene, der zweiten Seite der zweiten Materiallage gegenüberliegt, wobei auch zwischen diesen beiden Materiallagen, nämlich zwischen der zweiten Seite der zweiten Materiallage und der dritten Materiallage, zur Übertragung von Wärme und zur Kompensation von unterschiedlichen, winklig, insbesondere senkrecht zu ihrer Längserstreckung auftretenden mechanischen Kräften mehrere parallel mit Abstand zueinander angeordnete, längliche, insbesondere zylindrische, bevorzugt elastische Wärmeübertragungselemente verlaufen, insbesondere aus der ersten Materialart.

Besonders bevorzugt weist die erste Materiallage und/oder die dritte Materiallage eine Seite auf, mit der (ggf. jeweils) ein wärmeleitendes Bauteil, insbesondere ein Kühlblock aus Metall zur Kühlung eines elektronischen Bauteils, wie ein elektronischer Chip, oder eine insbesondere metallische Kühlfläche eines von einem Kühlmedium durchflossenen bzw. durchfließbaren Kühlbauteils, wärmeleitend verbindbar oder verbunden ist.

Was die Wärmeübertragungselemente betrifft, so können sie entsprechend den vorstehenden Ausführungen vorzugsweise so ausgebildet sein, dass sie winklig, insbesondere senkrecht zu ihrer jeweiligen Längserstreckung auftretende mechanische Kräfte kompensieren können, die durch Temperaturänderungen und hierdurch bedingte unterschiedliche Längenänderungen der oder von mindestens zwei der Materiallagen entstehen. Dies insbesondere, indem sie durch diese Kräfte vorzugsweise winklig, insbesondere senkrecht zu ihrer Längserstreckung biegbar bzw. verformbar ausgebildet sind, insbesondere elastisch.

Weiter können die Wärmeübertragungselemente Pins sein bzw. pinartig ausgebildet sein.

Jedes der Wärmeübertragungselemente weist jeweils zwei Enden auf, wobei jeweils eines der Enden jedes Wärmeübertragungselements einstückig mit der ersten oder mit der dritten Materiallage verbunden ist.

Bevorzugt kann die zweite Materiallage an der Seite oder an jeder der beiden Seiten mit einer (ggf. jeweils) anliegenden weiteren, vorzugweise quaderförmigen, insbesondere parallel zu der zweiten Materiallage verlaufenden Materiallage, vorzugsweise der ersten Materialart, insbesondere stoffschlüssig verbunden sein.

Jedes der Wärmeübertragungselemente kann jeweils zwei Enden aufweisen, wobei jeweils eines der Enden jedes Wärmeübertragungselements mit der (ggf. jeweiligen) weiteren Materiallage insbesondere stoffschlüssig verbunden ist, bevorzugt mittels einer Lötverbindung.

Die zweite Materiallage und die an den beiden Seiten der zweiten Materiallage anliegenden beiden weiteren Materiallagen können bevorzugt Bestandteil eines DBC (Direct Bonded Copper)-Substrats sein.

Weiter vorzugsweise kann die erste Materiallage eine größere Dicke aufweisen als die an der ersten Seite der zweiten Materiallage anliegende weitere Materiallage und/oder die dritte Materiallage eine größere Dicke als die an der zweiten Seite der zweiten Materiallage anliegende weitere Materiallage.

In mindestens einem Bereich des Kompensationsbauteils kann bezogen auf eine Ebene senkrecht zur Längserstreckung der Wärmeübertragungselemente oder parallel zur ersten und/oder zweiten Materiallage die Anzahl der voneinander beabstandeten Wärmeübertragungselemente pro mm² einen Wert zwischen 0,5 und 5 aufweisen.

Die (bei nicht durchgehend zylindrischen Wärmeübertragungselemente die insbesondere in Längsrichtung maximale) Querschnittsfläche der Wärmeübertragungselemente kann dabei einen Wert zwischen 0,05 mm² und 1,1 mm² aufweisen.

Die Länge der Wärmeübertragungselemente kann einen Wert zwischen 0,1 mm und 5 mm aufweisen, vorzugsweise zwischen 0,5 mm und 2 mm.

Der Durchmesser der Wärmeübertragungselemente kann einen Wert zwischen 0,1 mm und 5 mm aufweisen, vorzugsweise zwischen 0,2 mm und 1 mm.

Die zweite Materialart kann ein elektrisch isolierendes Material sein, insbesondere wärmeleitende Keramik, bevorzugt mit einem Wärmeleitwert von mindestens 15 W/mK.

Zusätzlich oder alternativ kann die erste Materialart ein elektrisch leitendes Material sein, insbesondere Metall, bevorzugt Kupfer.

Die Wärmeleitfähigkeit der ersten Materialart kann einen Wert von mindestens 200 W/mK aufweisen.

Ein Kompensationselement wie vorstehend beschrieben kann vorzugsweise integriert sein oder integriert werden in eine Vorrichtung, insbesondere Inverter zur Wandlung von Gleichspannung in Wechselspannung oder umgekehrt, mit mindestens einem zu kühlenden elektronischen Bauteil, insbesondere einem Chip, wobei das elektronische Bauteil zur Ableitung von im Betrieb der Vorrichtung bzw. im Betrieb des elektronischen Bauteils auftretender Wärme auf einem wärmeleitenden Kühlelement (insbesondere mit hoher thermischer Leitfähigkeit) sitzt, insbesondere einem Kühlblock aus Metall, vorzugsweise aus Kupfer. Dabei ist der Kühlblock mit der ersten Materiallage des Kompensationselements verbunden, insbesondere stoffschlüssig, und die dritte Materiallage des Kompensationselements mit einer insbesondere metallischen Kühlfläche eines von einem Kühlmedium durchflossenen bzw. durchfließbaren Kühlbauteils, insbesondere stoffschlüssig.

So eine Vorrichtung kann beispielsweise ein Inverter in einem Elektro-Fahrzeug sein, mit dem die Gleichspannung der Batterien bzw. Akkus in Wechselstrom gewandelt wird.

Weitere Merkmale der vorliegenden Erfindung ergeben sich aus den beigefügten Patentansprüchen, der nachfolgenden Beschreibung eines bevorzugten Ausführungsbeispiels der Erfindung sowie aus den beigefügten Zeichnungen.

Darin zeigt:
- Fig. 1: ein erfindungsgemäßes Kompensationsbauteil in Schrägansicht,
- Fig. 2: das Kompensationsbauteil aus Fig. 1 in Schrägansicht, teilweise geschnitten,
- Fig. 3: das Kompensationsbauteil aus Fig. 1 in einem Querschnitt,
- Fig. 4: eine Einzelheit des erfindungsgemäßen Kompensationsbauteils aus Fig. 1 in vergrößerter Darstellung, nämlich ein zwischen zwei Materiallagen angeordnetes Wärmeübertragungselement bei einer durch eine Temperaturänderung hervorgerufenen elastischen Verformung.

Beispielsweise bei der Kühlung von elektronischen (Hochleistungs-)Bauteilen, wie etwa elektronischen Chips eines Inverters eines Elektro-Fahrzeugs, ist es insbesondere bei hoher Betriebswärme, wie bereits eingangs beschrieben, vorteilhaft, die Wärme eines (massiven) Kühlelements bzw. Kühlblocks aus Metall, auf/an dem das elektronische Bauteil zur Kühlung desselben sitzt, an die metallische Kühlplatte eines Kühlbauteils weiterzuleiten, das durch ein durch das Kühlbauteil strömendes Kühlmedium gekühlt wird.

Dabei ist eine direkte Anordnung des Kühlblocks auf der Kühlplatte in der Regel nicht möglich, da in einer solchen Konstellation häufig eine elektrische Isolierung des metallischen Kühlblocks und der metallischen Kühlplatte erfolgen muss.

Auch die ausschließliche Verwendung einer einzelnen, elektrisch isolierenden Zwischenschicht aus einem elektrisch isolierenden Material, wie etwa (wärmeleitender) Keramik, mit der der Kühlblock einerseits und die beispielsweise aus Aluminium bestehende Kühlplatte andererseits verbunden wären, scheidet in der Regel aus. Denn selbst eine Wärme effektiv leitende Keramikart und ein gut wärmeleitendes Metall, wie Kupfer, unterscheiden sich in ihren Wärmeleitwerten. Zumindest bei Verwendung von sich deutlich unterscheidenden Schicht- bzw. Materialdicken wären bei Temperaturänderungen verschiedene Längenänderungen des Kühlblocks einerseits und der Keramikmateriallage andererseits bzw. der Keramikmateriallage einerseits und der Kühlplatte aus Metall andererseits die Folge, die Kräfte nach sich ziehen, die bei einer beispielsweise direkten stoffschlüssigen Verbindung zwischen diesen Materialien die jeweilige Verbindung zerstören könnten.

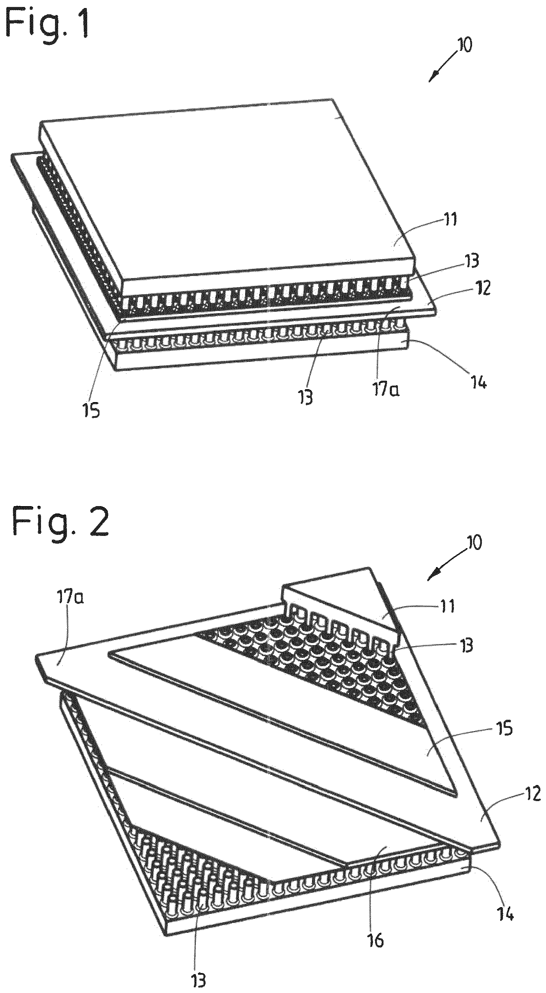

Das in den Fig. 1-4 dargestellte erfindungsgemäße Kompensationsbauteil 10 dient nun dazu, zwei solche (nicht gezeigte) oder ähnliche Materiallagen bzw. Materialien, also beispielsweise den beschriebenen (massiven) Kühlblock sowie die Kühlplatte des kühlmediumdurchflossenen Kühlbauteils, einerseits in besonders guter Weise wärmeleitend miteinander zu verbinden, dabei aber andererseits die vorgenannten Kräfte zu kompensieren, die aufgrund unterschiedlicher Wärmeleitfähigkeitswerte und/oder Materialdicken dieser Materialien bzw. Materiallagen bei Temperaturänderungen auftreten, wobei gleichzeitig zumindest im vorliegenden Beispielfall eine elektrische Entkopplung der Materiallagen bewirkt werden soll, also eine elektrische Entkopplung des Kühlblocks von der Kühlplatte.

Zu diesem Zweck weist das Kompensationsbauteil 10 eine erste (obere), vorliegend plattenförmige Materiallage 11 einer ersten wärmeleitenden Materialart auf, etwa Kupfer. Mit der (großflächigen) äußeren Seite (Oberseite) dieser Materiallage 11 kann dann beispielsweise der beschriebene (nicht gezeigte) Kühlblock für den elektronischen Chip (wärmeleitend) verbunden, bspw. verlötet werden.

Mit der ersten Materiallage 11 ist zur elektrischen Entkopplung bzw. Isolierung eine zweite Materiallage 12 aus elektrisch nicht leitendem Material wärmeleitend verbunden, vorliegend aus einer wärmeleitenden Keramik. Die wärmeleitende Verbindung der beiden Materiallagen 11 und 12 erfolgt durch eine erste Lage einer Vielzahl von jeweils voneinander beabstandeten, senkrecht zu den Materiallagen 11 und 12 verlaufenden länglichen, vorliegend als Pins ausgebildeten Wärmeübertragungselementen 13, die zwischen diesen Materiallagen 11 und 12 verlaufen bzw. angeordnet sind.

Das Kompensationsbauteil 10 weist weiter - aus demselben Material bestehend wie die erste Materiallage 11 - eine dritte (untere) Materiallage 14 auf, die parallel zu der ersten Materiallage 11 verläuft und wärmeleitend mit der zweiten Materiallage 12 und somit auch mit der ersten Materiallage 11 verbunden ist. Die wärmeleitende Verbindung zwischen der zweiten Materiallage 12 und der dritten Materiallage 14 erfolgt in ähnlicher Weise wie die wärmeleitende Verbindung zwischen der ersten Materiallage 11 und der zweiten Materiallage 12, und zwar über eine zweite Lage einer Vielzahl zwischen den Materiallagen 12, 13 angeordneten, jeweils mit diesen wärmeleitend verbundenen, länglichen Wärmeübertragungselementen 13, die voneinander beabstandet sind.

Mit der großflächigen Außenseite (Unterseite) dieser dritten Materiallage 14 kann die beschriebene, nicht dargestellte Kühlplatte aus Metall des ebenfalls nicht gezeigten, kühlmediumdurchflossenen Kühlbauteils verbunden werden, sodass insgesamt die Wärme des Kühlblocks über die erste Materiallage 11, die erste Lage von Wärmeübertragungselementen 13, die zweite Materiallage 12, die zweite Lage von Wärmeübertragungselementen 13 sowie die dritte Materiallage 14 an die Kühlplatte des nicht dargestellten Kühlbauteils abgeleitet wird.

Die länglichen Wärmeübertragungselemente 13 sind vorliegend zylindrisch ausgebildet und winklig, insbesondere quer zur ihrer Längserstreckung elastisch biegbar bzw. elastisch verformbar.

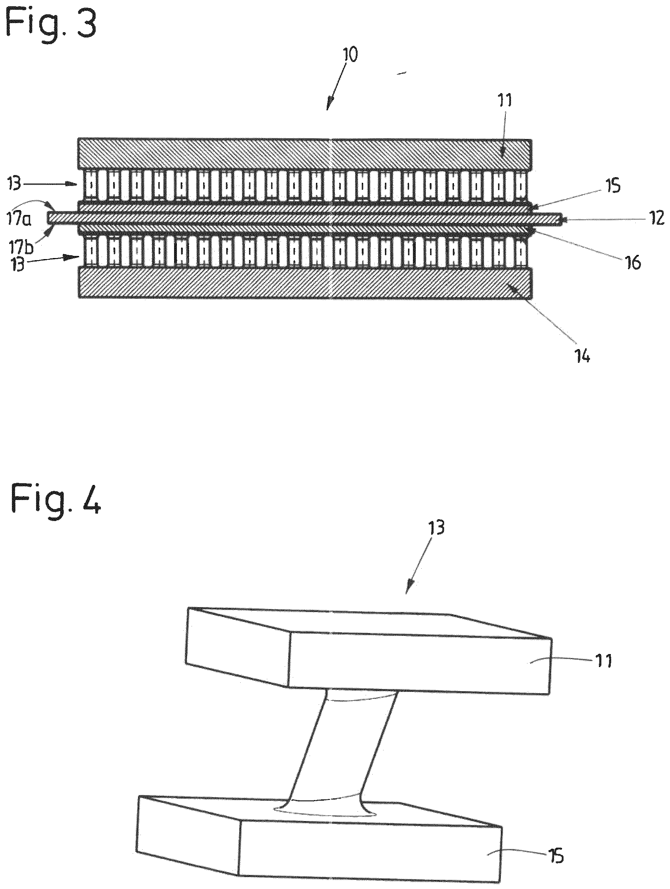

Sie sind derart (dünn) ausgebildet, dass sie die oben beschriebenen, quer zu ihrer jeweiligen Längserstreckung bei Temperaturänderungen auftretenden mechanischen Kräfte kompensieren können, indem sie sich entsprechend aus einer zu den Materiallagen 11, 12 und 14 senkrecht verlaufenden Stellung verformen bzw. verbiegen können in eine schräg zu diesen Materiallagen verlaufenden Stellung, vgl. bspw. die Darstellung in Fig. 4 (exemplarisch für nur ein Wärmeübertragungselement 13). Gleichzeitig ist ihre Anzahl pro Flächeneinheit möglichst groß gewählt, um insgesamt einen möglichst hohen Wärmefluss zu ermöglichen.

Im vorliegenden Fall sind die einen Enden der Wärmeübertragungselemente 13 jeweils einstückig mit der ersten bzw. der dritten Materiallage 11 bzw. 14 verbunden und bestehen entsprechend ebenfalls aus Metall bzw. Kupfer. Sie können beispielsweise durch Fließpressen eines geeigneten, die spätere Materiallage 11 bzw. 14 bildenden Metall- bzw. Kupfer-Materialblocks gefertigt werden.

Die jeweils anderen Enden der Wärmeübertragungselemente 13 sind dagegen jeweils mittelbar mit der zweiten Materiallage 12 verbunden, nämlich jeweils über Lötverbindungen mit weiteren Materiallagen 15 bzw. 16, die jeweils unter Bildung eines DBC (Direct Bonded Copper)-Substrats an jeweils einer der sich jeweils gegenüberliegenden großflächigen Seiten 17a, 17b der Materiallage 12 angeordnet und mit dieser verbunden sind.

### Bezugszeichenliste:

- 10: Kompensationsbauteil
- 11: erste Materiallage
- 12: zweite Materiallage
- 13: Wärmeübertragungselemente
- 14: dritte Materiallage
- 15: weitere Materiallage
- 16: weitere Materiallage
- 17a: großflächige Seite
- 17b: großflächige Seite

## Patentansprüche

1. Kompensationsbauteil mit einer ersten, vorzugsweise quaderförmigen Materiallage (11) aus wärmeleitendem Material, insbesondere einer ersten Materialart, vorzugsweise Metall, mit einer mit Abstand zu der ersten Materiallage (11) insbesondere in einer parallelen Ebene zu dieser verlaufenden, vorzugsweise quaderförmigen zweiten Materiallage (12) aus wärmeleitendem Material, insbesondere einer anderen zweiten, bevorzugt elektrisch nicht leitenden Materialart, insbesondere Keramik, wobei zwischen den beiden Materiallagen (11, 12) zur Übertragung von Wärme von der einen zur anderen Materiallage (11, 12) und zur Kompensation von unterschiedlichen, winklig, insbesondere senkrecht zu ihrer jeweiligen Längserstreckung auftretenden mechanischen Kräften mehrere, insbesondere jeweils winklig, bevorzugt senkrecht zur Längserstreckung biegbare, parallele, mit Abstand zueinander angeordnete, längliche, insbesondere zylindrische, bevorzugt elastisch verformbare, insbesondere als Pins oder pinartig ausgebildete Wärmeübertragungselemente (13) aus einem wärmeleitenden Material verlaufen, vorzugsweise aus der ersten Materialart, wobei die Wärmeübertragungselemente (13) zwischen einer ersten (insbesondere großflächigen) Seite der zweiten Materiallage (12) und der ersten Materiallage (11) angeordnet sind, und wobei die zweite Materiallage (12) eine ihrer ersten Seite gegenüberliegende (insbesondere großflächige) zweite Seite aufweist, **dadurch gekennzeichnet, dass** das Kompensationsbauteil eine dritte wärmeleitende, vorzugsweise quaderförmige Materiallage (14) aufweist, insbesondere ebenfalls der ersten Materialart, die mit Abstand, insbesondere in einer parallelen Ebene, der zweiten Seite der zweiten Materiallage (12) gegenüberliegt, wobei auch zwischen diesen beiden Materiallagen, nämlich zwischen der zweiten Seite der zweiten Materiallage (12) und der dritten Materiallage (14), zur Übertragung von Wärme und zur Kompensation von unterschiedlichen, winklig, insbesondere senkrecht zu ihrer jeweiligen Längserstreckung auftretenden mechanischen Kräften mehrere parallele, mit Abstand zueinander angeordnete, längliche, insbesondere zylindrische, bevorzugt elastisch verformbare, insbesondere als Pins oder pinartig ausgebildete Wärmeübertragungselemente (13) aus einem wärmeleitenden Material verlaufen, insbesondere aus der ersten Materialart, und dass jedes der Wärmeübertragungselemente (13) jeweils zwei Enden aufweist, wobei jeweils eines der Enden jedes Wärmeübertragungselements (13) einstückig mit der ersten oder mit der dritten Materiallage (11, 14) verbunden ist.

2. Kompensationsbauteil gemäß Anspruch 1, **dadurch gekennzeichnet, dass** die Wärmeübertragungselemente (13), insbesondere in ihrer jeweiligen Länge und/oder ihrem jeweiligen Querschnitt, derart ausgebildet sind, dass sie winklig, insbesondere senkrecht zu ihrer jeweiligen Längserstreckung auftretende mechanische Kräfte kompensieren können, die durch Temperaturänderungen und hierdurch bedingte unterschiedliche Längenänderungen der oder von mindestens zwei der Materiallagen (11, 12, 14) entstehen, insbesondere indem sie durch diese Kräfte insbesondere winklig, vorzugsweise senkrecht zur ihrer Längserstreckung biegbar bzw. verformbar ausgebildet sind, bevorzugt elastisch.

3. Kompensationsbauteil gemäß Anspruch 1 oder 2, **dadurch gekennzeichnet, dass** die zweite Materiallage (12) an der Seite oder an jeder der beiden Seiten mit einer (ggf. jeweils) anliegenden weiteren, vorzugweise quaderförmigen, insbesondere parallel zu der zweiten Materiallage (12) verlaufenden Materiallage (15, 16), vorzugsweise der ersten Materialart, insbesondere stoffschlüssig verbunden ist.

4. Kompensationsbauteil gemäß Anspruch 3, **dadurch gekennzeichnet, dass** jeweils eines der Enden jedes Wärmeübertragungselements (13) mit der (ggf. jeweiligen) weiteren Materiallage (15, 16) insbesondere stoffschlüssig verbunden ist, bevorzugt mittels einer Lötverbindung.

5. Kompensationsbauteil gemäß einem oder mehreren der vorhergehenden Ansprüche, mindestens gemäß Anspruch 3, **dadurch gekennzeichnet, dass** die zweite Materiallage (12) und die an den beiden Seiten der zweiten Materiallage (12) anliegenden beiden weiteren Materiallagen (15, 16) Bestandteil eines DBC (Direct Bonded Copper)-Substrats sind.

6. Kompensationsbauteil gemäß einem oder mehreren der vorhergehenden Ansprüche, **dadurch gekennzeichnet, dass** die erste Materiallage (11) eine größere Dicke aufweist als die an der ersten Seite der zweiten Materiallage (12) anliegende weitere Materiallage (15), und/oder dass die dritte Materiallage (14) eine größere Dicke aufweist als die an der zweiten Seite der zweiten Materiallage (12) anliegende weitere Materiallage (16).

7. Kompensationsbauteil gemäß einem oder mehreren der vorhergehenden Ansprüche, **dadurch gekennzeichnet, dass** in mindestens einem Bereich des Kompensationsbauteils bezogen auf eine Ebene senkrecht zur Längserstreckung der Wärmeübertragungselemente (13) oder parallel zur ersten und/oder zweiten Materiallage die Anzahl der Wärmeübertragungselemente (13) pro mm² einen Wert zwischen 0,5 und 5 aufweist.

8. Kompensationsbauteil gemäß einem oder mehreren der vorhergehenden Ansprüche, **dadurch gekennzeichnet, dass** die insbesondere in Längsrichtung maximale Querschnittsfläche der Wärmeübertragungselemente (13) einen Wert zwischen 0,05 mm² und 1,1 mm² aufweist, und/oder dass die Länge der Wärmeübertragungselemente (13) einen Wert zwischen 0,1 mm und 5 mm aufweist, vorzugsweise zwischen 0,5 mm und 2 mm, und/oder dass der Durchmesser der Wärmeübertragungselemente (13) einen Wert zwischen 0,1 mm und 5 mm aufweist, vorzugsweise zwischen 0,2 mm und 1 mm.

9. Kompensationsbauteil gemäß einem oder mehreren der vorhergehenden Ansprüche, **dadurch gekennzeichnet, dass** die zweite Materialart ein elektrisch isolierendes Material ist, insbesondere Keramik, und/oder dass die erste Materialart ein elektrisch leitendes Material ist, insbesondere Metall, bevorzugt Kupfer.

10. Kompensationsbauteil gemäß einem oder mehreren der vorhergehenden Ansprüche, **dadurch gekennzeichnet, dass** die Wärmeleitfähigkeit der ersten Materialart einen Wert von mindestens 200 W/mK aufweist, und/oder dass die Wärmeleitfähigkeit der zweiten Materialart einen Wert von mindestens 15 WmK aufweist.

11. Kompensationsbauteil gemäß einem oder mehreren der vorhergehenden Ansprüche, **dadurch gekennzeichnet, dass** die erste Materiallage (11) und/oder die dritte Materiallage (14) eine Seite aufweist, mit der (ggf. jeweils) ein wärmeleitendes Bauteil, insbesondere ein Kühlblock aus Metall zur Kühlung eines elektronischen Bauteils, wie ein elektronischer Chip, oder eine insbesondere metallische Kühlfläche eines von einem Kühlmedium durchflossenen bzw. durchfließbaren Kühlbauteils, wärmeleitend verbindbar oder verbunden ist.

12. Vorrichtung, insbesondere Inverter zur Wandlung von Gleichspannung in Wechselspannung oder umgekehrt, mit mindestens einem zu kühlenden elektronischen Bauteil, insbesondere einem Chip, wobei das elektronische Bauteil zur Ableitung von im Betrieb der Vorrichtung auftretender Wärme auf einem wärmeleitenden Kühlelement angeordnet ist, insbesondere einem Kühlblock aus Metall, vorzugsweise aus Kupfer, und mit einem Kompensationsbauteil gemäß einem oder mehreren der vorhergehenden Ansprüche 1-11, wobei der Kühlblock mit der ersten Materiallage (11) des Kompensationselements wärmeleitend verbunden ist, insbesondere stoffschlüssig, und wobei die dritte Materiallage (14) des Kompensationselements mit einer insbesondere metallischen Kühlfläche eines von einem Kühlmedium durchflossenen bzw. durchfließbaren Kühlbauteils der Vorrichtung verbunden ist, insbesondere stoffschlüssig.

13. Vorrichtung gemäß Anspruch 12, **dadurch gekennzeichnet, dass** das Kompensationsbauteil ein oder mehrere weitere Merkmale der vorhergehenden Ansprüche 1-11 aufweist.

## Claims

1. A compensation component with a first, preferably cuboid material layer (11) of heat-conducting material, in particular of a first type of material, preferably metal, with a preferably cuboid second material layer (12) of heat-conducting material running at a distance from the first material layer (11), in particular in a parallel plane to the latter, in particular of another second, preferably electrically non-conductive type of material, in particular ceramic, wherein a plurality of elongated, in particular cylindrical, especially elastically deformable heat-transfer elements (13) of a heat-conducting material, preferably of the first type of material, in particular in the form of pins or pin-like, in particular each arranged at an angle, preferably perpendicular to the longitudinal extension, bendable, parallel and spaced apart from one another, run between the two material layers (11, 12) for the transfer of heat from the one to the other material layer (11, 12) and for the compensation of different mechanical forces occurring at an angle, in particular perpendicular to their respective longitudinal extension, wherein the heat-conducting elements (13) are arranged between a first (in particular large-area) side of the second material layer (12) and the first material layer (11), and wherein the second material layer (12) comprises a second (in particular large-area) side lying opposite its first side, **characterised in that** the compensation component comprises a third heat-conducting, preferably cuboid material layer (14), in particular also of the first material type, which lies spaced apart, in particular in a parallel plane, opposite the second side of the second material layer (12), wherein a plurality of parallel, mutually spaced-apart, elongated, in particular cylindrical, preferably elastically deformable heat-transfer elements (13) of a heat-conducting material, in particular of the first type of material, formed in particular as pins or pin-like, also run between these two material layers, i.e. between the second side of the second material layer (12) and the third material layer (14), for the transfer of heat and for the compensation of different mechanical forces occurring at an angle, in particular perpendicular to their respective longitudinal extension, and that each of the heat-transfer elements (13) comprises two ends, wherein in each case one of the ends of each heat-transfer element (13) is connected in one piece to the first or to the third material layer (11, 14).

2. The compensation component according to claim 1, **characterised in that** the heat-transfer elements (13), in particular in their respective length and/or their respective cross-section, are constituted in such a way that they can compensate for the mechanical forces occurring at an angle, in particular perpendicular to their respective longitudinal extension, which arise due to temperature changes and thus induced different changes in length of the or at least at least two of the material layers (11, 12, 14), in particular whereby they can be bent or deformed, in particular elastically, by these forces in particular at an angle, preferably perpendicular to their longitudinal extension.

3. The compensation component according to claim 1 or 2, **characterised in that** the second material layer (12) is connected at the side or to each of the two sides, in particular in a materially bonded manner, to a material layer (15, 16), preferably of the first material type, to an (if applicable respective) abutting further, preferably cuboid material layer (15, 16), in particular running parallel to the second material layer (12).

4. The compensation component according to claim 3, **characterised in that** in each case one of the ends of each heat-transfer element (13) is connected in a firmly bonded manner, preferably by means of a solder connection, to the (if appropriate respective) further material layer (15, 16).

5. The compensation component according to one or more of the preceding claims, at least according to claim 3, **characterised in that** the second material layer (12) and the two further material layers (15, 16) lying against the two sides of the second material layer (12) are a component of a DBC (direct bonded copper) substrate.

6. The compensation component according to one or more of the preceding claims, **characterised in that** the first material layer (11) has a greater thickness than the further material layer (15) lying against the first side of the second material layer (12), and/or that the third material layer (14) has a greater thickness than the further material layer (16) lying against the second side of the second material layer (12).

7. The compensation component according to one or more of the preceding claims, **characterised in that** the number of heat-transfer elements (13) per mm² has a value between 0.5 and 5 in at least one area of the compensation component relative to a plane perpendicular to the longitudinal extension of the heat-transfer elements (13) or parallel to the first and/or second material layer.

8. The compensation component according to one or more of the preceding claims, **characterised in that** the maximum cross-section of the heat-transfer elements (13) in particular in the longitudinal direction has a value between 0.05 mm² and 1.1 mm², and/or the length of the heat-transfer elements (13) has a value between 0.1 mm and 5 mm, preferably between 0.5 mm and 2 mm, and/or that the diameter of the heat-transfer elements (13) has a value between 0.1 mm and 5 mm, preferably between 0.2 mm and 1 mm.

9. The compensation component according to one or more of the preceding claims, **characterised in that** the second type of material is an electrically insulating material, in particular ceramic, and/or that the first type of material is an electrically conductive material, in particular metal, preferably copper.

10. The compensation component according to one or more of the preceding claims, **characterised in that** the thermal conductivity of the first type of material has a value of at least 200 W/mK, and/or that the thermal conductivity of the second type of material has a value of at least 15 W/mK.

11. The compensation component according to one or more of the preceding claims, **characterised in that** the first material layer (11) and/or the third material layer (14) has a side, to which (if appropriate in each case) a heat-conducting component, in particular a cooling block made of metal for cooling an electronic component, such as in the electronic chip, or an in particular metallic cooling surface of a cooling component through which a cooling medium flows or can flow, is or can be connected in a heat-conducting manner.

12. A device, in particular an inverter for converting direct voltage into alternating voltage or vice versa, with at least one electronic component to be cooled, in particular a chip, wherein the electronic component is arranged for the dissipation of heat occurring during operation of the device to a heat-conducting cooling element, in particular a cooling block made of metal, preferably of copper, and a compensation component according to one or more of the preceding claims 1 - 11, wherein the cooling block is connected in a heat-conducting manner to the first material layer (11) of the compensation element, in particular in a firmly bonded manner, and wherein the third material layer (14) of the compensation element is connected, in particular in a firmly bonded manner, to an in particular metallic cooling surface of a cooling component of the device through which a cooling medium flows or can flow.

13. The device according to claim 12, **characterised in that** the compensation component comprises one or more further features of the preceding claims 1-11.

## Revendications

1. Composant de compensation, doté d'une première couche de matière (11), de préférence de forme parallélépipédique, en une matière thermoconductrice, notamment en un premier type de matière, de préférence en métal, doté d'une deuxième couche de matière (12), de préférence de forme parallélépipédique, s'écoulant avec un écart par rapport à la première couche de matière (11), notamment dans un plan parallèle par rapport à celle-ci, en une matière thermoconductrice, de préférence en un autre, deuxième type de matière, de manière préférentielle non conductrice électrique, notamment en céramique, entre les deux couches de matières (11, 12), pour le transfert de chaleur de l'une des couches de matières (11, 12) vers l'autre et pour la compensation de différentes forces mécaniques, se produisant sous un angle, notamment à la perpendiculaire de leur extension longitudinale respective, s'écoulant notamment chacun sous un angle plusieurs éléments de transfert thermique (13) en une matière thermoconductrice, de préférence du premier type de matière, de préférence flexibles à la perpendiculaire de l'extension longitudinale, parallèles, placés avec un écart mutuel, allongés, notamment cylindriques, de préférence élastiquement déformables, conçus notamment sous la forme de broches ou du type de broches, les éléments de transfert thermique (13) étant placés entre une première face (notamment de grande surface) de la deuxième couche de matière (12) et la première couche de matière (11) et la deuxième couche de matière (12) comportant une deuxième face (notamment de grande surface) placée à l'opposée de la première face, **caractérisé en ce que** le composant de compensation comporte une troisième couche de matière (14) thermoconductrice, notamment de forme parallélépipédique, notamment également du premier type de matière, qui est opposée avec un écart, notamment dans un plan parallèle à la deuxième face de la deuxième couche de matière (12), également entre lesdites deux couches de matières, à savoir entre la deuxième face de la deuxième couche de matière (12) et la troisième couche de matière (14), pour le transfert thermique et pour la compensation de différentes forces mécaniques se produisant sous un angle, notamment à la perpendiculaire de leur extension respective s'écoulant plusieurs éléments de transfert thermique (13) en une matière thermoconductrice, notamment dans le premier type de matière, parallèles, placés avec un écart mutuel, allongés, notamment cylindriques, de préférence élastiquement déformables, conçus notamment en tant que broches ou du type de broches et **en ce que** chacun des éléments de transfert thermique (13) comporte respectivement deux extrémités, chaque fois l'une des extrémités de chaque élément de transfert thermique (13) étant assemblé en monobloc avec la première ou avec la troisième couche de matière (11, 14).

2. Composant de compensation selon la revendication 1, **caractérisé en ce que**, notamment dans leur longueur respective et / ou dans leur section transversale respective, les éléments de transfert thermique (13) sont conçus de sorte à pouvoir compenser des forces mécaniques se produisant sous un angle, notamment à la perpendiculaire de leur extension longitudinale respective, qui naissent suite à des variations thermiques et à différentes variations de longueur dues à ces dernières des ou d'au moins deux des couches de matières (11, 12, 14), notamment **en ce que** du fait desdites forces, ils sont conçus en étant flexibles ou déformables notamment sous un angle, de préférence à la perpendiculaire de leur extension longitudinale, notamment en étant élastiques.

3. Composant de compensation selon la revendication 1 ou 2, **caractérisé en ce que** sur la face ou sur chacun des deux faces, la deuxième couche de matière (12) est assemblée, notamment par conjugaison de matières avec une couche de matière (15, 16) supplémentaire, adjacente (respectivement le cas échéant), de préférence de forme parallélépipédique, s'écoulant notamment à la parallèle de la deuxième couche de matière (12), de préférence du premier type de matière.

4. Composant de compensation selon la revendication 3, **caractérisé en ce que** respectivement l'une des extrémités de chaque élément de transfert thermique (13) est assemblée notamment par conjugaison de matières, de manière préférentielle au moyen d'un joint brasé avec la couche de matière (15, 16) supplémentaire (le cas échéant respective).

5. Composant de compensation selon l'une quelconque ou plusieurs des revendications précédentes, au moins selon la revendication 3, **caractérisé en ce que** la deuxième couche de matière (12) et les deux couches de matières (15, 16) supplémentaires adjacentes aux deux faces de la deuxième couche de matière (12) sont parties intégrantes d'un substrat DBC (en cuivre à liaison directe).

6. Composant de compensation selon l'une quelconque ou plusieurs des revendications précédentes, **caractérisé en ce que** la première couche de matière (11) présente une épaisseur supérieure à celle de la couche de matière (15) supplémentaire adjacente à la première face de la deuxième couche de matière (12) et / ou **en ce que** la troisième couche de matière (14) présente une épaisseur supérieure à celle de la couche de matière (16) supplémentaire adjacente à la deuxième face de la deuxième couche de matière (12).

7. Composant de compensation selon l'une quelconque ou plusieurs des revendications précédentes, **caractérisé en ce que** dans au moins une zone du composant de compensation, rapporté à un plan perpendiculaire à l'extension longitudinale des éléments de transfert thermique (13) ou à la parallèle de la première et / ou de la deuxième couche de matière, le nombre des éléments de transfert thermique (13) par mm² présente une valeur comprise entre 0,5 et 5.

8. Composant de compensation selon l'une quelconque ou plusieurs des revendications précédentes, **caractérisé en ce que** la surface de section transversale maximale des éléments de transfert thermique (13), notamment dans la direction longitudinale présente une valeur comprise entre 0,05 mm² et 1,1 mm² et / ou **en ce que** la longueur des éléments de transfert thermique (13) présente une valeur comprise entre 0,1 mm et 5 mm, de préférence entre 0,5 mm et 2 mm, et / ou **en ce que** le diamètre des éléments de transfert thermique (13) présente une valeur comprise entre 0,1 mm et 5 mm, de préférence entre 0,2 mm et 1 mm.

9. Composant de compensation selon l'une quelconque ou plusieurs des revendications précédentes, **caractérisé en ce que** le deuxième type de matière est une matière isolante électrique, notamment une céramique et / ou **en ce que** le premier type de matière est une matière conductrice électrique, notamment un métal, de préférence du cuivre.

10. Composant de compensation selon l'une quelconque ou plusieurs des revendications précédentes, **caractérisé en ce que** la conductibilité thermique du premier type de matière présente une valeur d'au moins 200 W/mK et / ou **en ce que** la conductibilité thermique du deuxième type de matière présente une valeur d'au moins 15 W/mK.

11. Composant de compensation selon l'une quelconque ou plusieurs des revendications précédentes, **caractérisé en ce que** la première couche de matière (11) et / ou la troisième couche de matière (14) comporte une face avec laquelle (le cas échéant respectivement) un composant conducteur thermique, notamment un bloc de refroidissement en métal, destiné à refroidir un composant électronique, tel qu'une puce électronique ou une surface de refroidissement notamment métallique d'un composant de refroidissement traversé ou susceptible d'être traversé par un fluide de refroidissement est assemblé ou susceptible d'être assemblé de manière conductrice thermique.

12. Dispositif, notamment onduleur, destiné à convertir une tension continue en une tension alternative ou inversement, doté d'au moins un composant électronique qui doit être refroidi, notamment une puce, pour dissiper de la chaleur se produisant en cours de fonctionnement du dispositif, le composant électronique étant =- placé sur un élément de refroidissement conducteur thermique, notamment sur un bloc de refroidissement en métal, de préférence en cuivre et doté d'un composant de compensation selon l'une quelconque ou plusieurs des revendications 1 à 11 précédentes, le bloc de refroidissement étant assemblé de manière conductrice thermique, notamment par conjugaison de matières avec la première couche de matière (11) de l'élément de compensation et la troisième couche de matière (14) de l'élément de compensation étant assemblée, notamment par conjugaison de matières avec une surface de refroidissement, notamment métallique d'un composant de refroidissement du dispositif, traversé ou susceptible d'être traversé par un fluide de refroidissement.

13. Dispositif selon la revendication 12, **caractérisé en ce que** le composant de compensation présente un ou plusieurs attributs des revendications 1 à 11 précédentes.
